# EUROPEAN PATENT APPLICATION

(11) **EP 4 589 640 A1**
(43) Date of publication of application: **23.07.2025**
(21) Application number: 24222648.8
(22) Date of filing: 20.12.2024
(51) Int. Cl.: H01L 21/56, H01L 23/433, H01L 23/31, H01L 21/683

(54) **SEMICONDUCTOR PACKAGE AND METHOD OF MANUFACTURING THE SAME**

(30) Priority: 22.01.2024 TW 113102484
(71) Applicant: Chipbond Technology Corporation, 300 Hsinchu (TW)
(72) Inventor: SHIH, Cheng-Hung, Lugang Township, Changhua (TW); HSIEH, Yung-Wei, Hsinchu City (TW); CHENG, Pai-Sheng, Hsinchu City (TW)
(74) Representative: Beck & Rössig European Patent Attorneys

(57) **Abstract**

In a method of manufacturing a semiconductor package, a half groove (125) is formed between a first surface (121) and a lateral surface (123) of an encapsulation layer (150), the first surface of the encapsulation layer is adhered on a carrier (T3) such that the half groove becomes a sheltering space located between the encapsulation layer and the carrier, then a heat-dissipation layer (130) is formed on a second surface (122) of the encapsulation layer to obtain a semiconductor package. During formation of the heat-dissipation layer, the sheltering space can avoid metal residues from accumulating in a gap between the carrier and the first surface of the encapsulation layer to contaminate the semiconductor package.

## Description

### FIELD OF THE INVENTION

This invention relates to a semiconductor package, and more particularly to a semiconductor package with a heat-dissipation layer formed on an encapsulation layer.

### BACKGROUND OF THE INVENTION

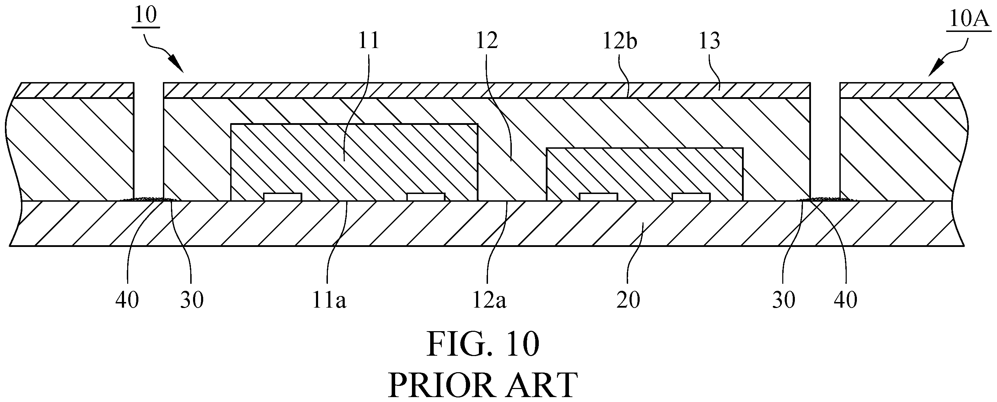

A conventional semiconductor package 10 is shown in Fig. 10. Multiple encapsulants 10A are adhered to a carrier 20 and each of them has a die 11 and an encapsulation layer 12. An active surface 11a of the die 11 and a first surface 12a of the encapsulation layer 12 are adhered on the carrier 20, and a heat-dissipation layer 13 is formed on a second surface 12b of the encapsulation layer 12 through sputtering process to obtain the conventional semiconductor package 10.

During sputtering formation of the heat-dissipation layer 13 on the second surface 12b of the encapsulation layer 12, a gap 30 may be observed between the encapsulation layer 12 and the carrier 20 due to physical properties of the die 11, the encapsulation layer 12 and the carrier 20 or process environment variation (e.g. temperature). Spattering target atoms may accumulate on the carrier 20 and in the gap 30 to become metal residues 40 during sputtering process, and the metal residues 40 may contaminate the die 11 to lower quality and yield of the semiconductor package 10.

### SUMMARY OF THE INVENTION

One object of the present invention is to provide a semiconductor package and its manufacturing method. Because of a half groove formed on an encapsulation layer, metal residues will not accumulate in a gap between the encapsulation layer and a carrier during formation of a heat-dissipation layer to reduce quality and yield of the semiconductor package.

A semiconductor package of the present invention includes a die, an encapsulation layer and a heat-dissipation layer. The encapsulation layer encapsulates the die and has a first surface, a second surface, a lateral surface and a half groove. The half groove surrounds the first surface, and it is located between the first surface and the lateral surface and has a first edge adjacent to the first surface and a second edge adjacent to the lateral surface. The second surface of the encapsulation layer is covered by the heat-dissipation layer.

In a method of manufacturing semiconductor packages of the present invention, package units are adhered to a third carrier and a heat-dissipation layer is formed on each of the package units to obtain the semiconductor packages. Each of the package units includes a die and an encapsulation layer which encapsulates the die and has a first surface, a second surface, a lateral surface and a half groove. The half groove surrounds the first surface, and it is located between the first surface and the lateral surface and has a first edge adjacent to the first surface and a second edge adjacent to the lateral surface. The first surface of the encapsulation layer is adhered on the third carrier such that the half groove becomes a sheltering space located between the encapsulation layer and the third carrier. The second surface of the encapsulation layer is covered by the heat-dissipation layer.

Advantageous embodiments are set out in further claims.

As the heat-dissipation layer is formed on the second surface of the encapsulation layer, the sheltering space formed because of the half groove which surrounds the first surface and is located between the first surface and the lateral surface can prevent metal residues from accumulating in a gap between the first surface of the encapsulation layer and the third carrier and contaminating the die.

A "half groove" may be derived from a groove by cutting through its bottom. Whereas a groove may be formed by a bottom between two opposing lateral walls, a half groove may have a bottom and just one lateral wall.

### BRIEF DESCRIPTION OF DRAWING

Figs. 1 to 8D are cross-section view diagrams illustrating a method of manufacturing semiconductor packages in accordance with different embodiments of the present invention.
Figs. 9A to 9D are cross-section view diagrams illustrating semiconductor packages in accordance with different embodiments of the present invention.
Fig. 10 is a cross-section view diagram illustrating a conventional semiconductor package.

### DETAILED DESCRIPTION OF THE INVENTION

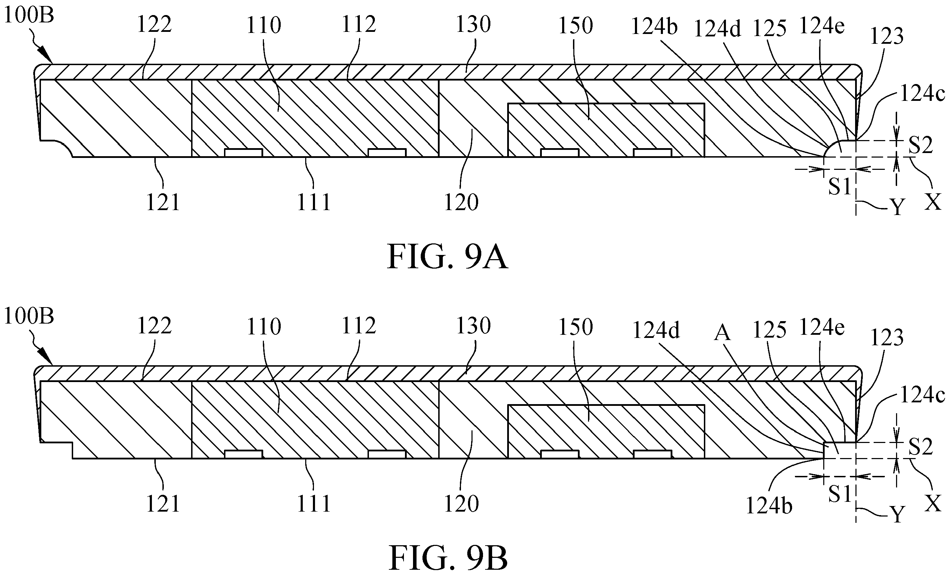

With reference to Figs. 9A to 9D, a semiconductor package 100B includes a die 110, an encapsulation layer 120 and a heat-dissipation layer 130, and preferably, the semiconductor package 100B further includes at least one electronic component 150, e.g. another die or a passive component. The die 110 has an active surface 111 and a back surface 112. The encapsulation layer 120 encapsulates the die 110 and the electronic component 150, and it has a first surface 121, a second surface 122, a lateral surface 123 and a half groove 125. The active surface 111 of the die 110 is not covered by the encapsulation layer 120 so the active surface 111 is visible from the first surface 121 of the encapsulation layer 120. In other embodiments, a redistribution layer may be provided on the active surface 111 of the die 110 and/or the first surface 121 of the encapsulation layer 120. The half groove 125 surrounds the first surface 121 and is located between the first surface 121 and the lateral surface 123 of the encapsulation layer 120. The half groove 125 has a first edge 124b and a second edge 124c which are adjacent to the first surface 121 and the lateral surface 123 of the encapsulation layer 120, respectively. The back surface 112 of the die 110 is visible from the second surface 122 of the encapsulation layer 120, and they are covered by the heat-dissipation layer 130. And preferably, the lateral surface 123 of the encapsulation layer 120 is also covered by the heat-dissipation layer 130.

With reference to Figs. 9A to 9D, a first imaginary line X extending along the first surface 121 of the encapsulation layer 120 passes through the first edge 124b, and a second imaginary line Y extending along the lateral surface 123 of the encapsulation layer 120 passes through the second edge 124c. A first distance S1 from the first edge 124b to the second imaginary line Y is greater than or equal to 3 µm and less than or equal to 10 µm (3 µm ≤ S1 ≤ 10 µm). A second distance S2 from the second edge 124c to the first imaginary line X is greater than or equal to 5 µm and less than or equal to 120 µm (5 µm ≤ S2 ≤ 120 µm). And the quotient of S2 divided by S1 is greater than or equal to 0.5 and less than or equal to 40 (0.5 ≤ S2/S1 ≤ 40).

The semiconductor packages 100B shown in Figs. 9A to 9D have different shapes of the half grooves 125. The half groove 125 shown in Fig. 9A has a groove lateral surface 124d and a groove bottom surface 124e, the groove lateral surface 124d is an arc surface connected to the groove bottom surface 124e, and the second edge 124c is located on the groove bottom surface 124e. In the embodiment shown in Fig. 9A, the groove lateral surface 124d is connected to the first surface 121 of the encapsulation layer 120, and the first edge 124b of the half groove 125 is located on the groove lateral surface 124d.

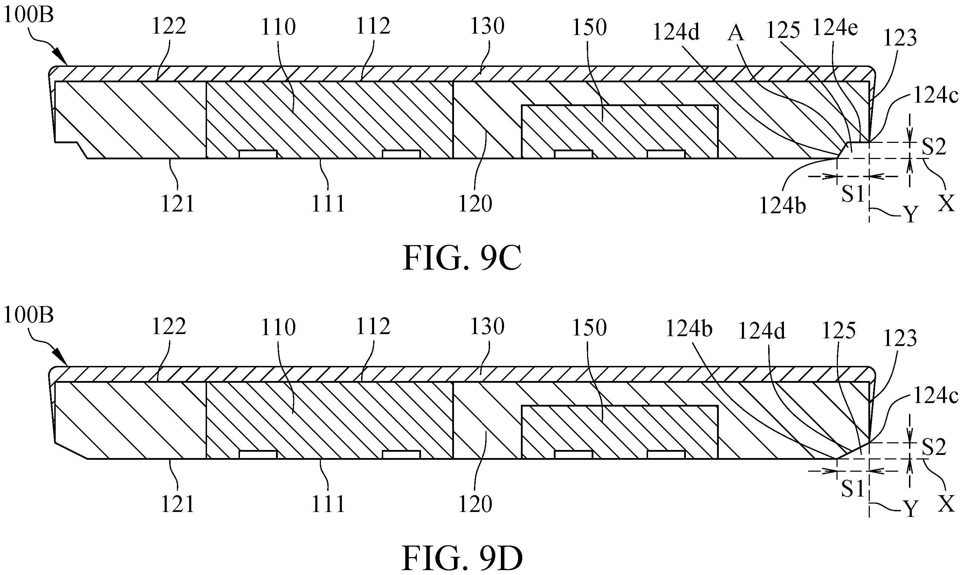

With reference to Figs. 9B and 9C, the groove lateral surface 124d is connected to the groove bottom surface 124e and the first surface 121 of the encapsulation layer 120. Different to the half groove 125 shown in Fig. 9A, an included angle A greater than or equal to 90 degrees exists between the groove lateral surface 124d and the groove bottom surface 124e in the embodiments of Figs. 9B and 9C. The groove lateral surface 124d is perpendicular to the groove bottom surface 124e in the embodiment shown in Fig. 9B so the included angle A is 90 degrees. The included angle A is larger than 90 degrees in the embodiment shown in Fig. 9C.

Different to the embodiments shown in Figs. 9A to 9C, the half groove 125 of the embodiment shown in Fig. 9D has no the groove bottom surface 124e, and its groove lateral surface 124d is a sloping surface. With reference to Fig. 9D, the groove lateral surface 124d is connected to the first surface 121 and the lateral surface 123 of the encapsulation layer 120, and the first edge 124b and the second edge 124c of the half groove 125 are located on the groove lateral surface 124d.

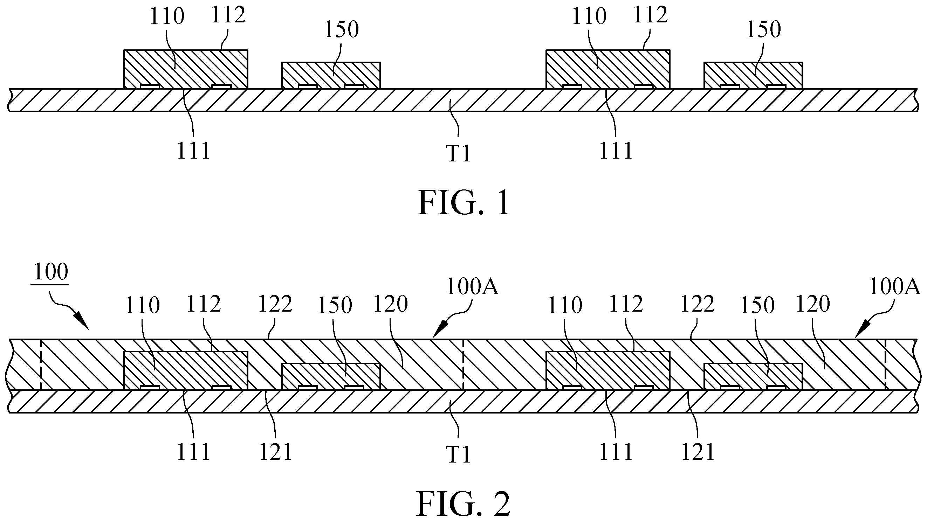

Figs. 1 to 8D show a method of manufacturing semiconductor packages 100B. With reference to Fig. 1, a packaging process is proceeded first. Multiple dies 110 are adhered to a first carrier T1 via the active surface 111, and preferably, the electronic components 150 are also adhered to the first carrier T1.

With reference to Fig. 2, the dies 110 and the electronic components 150 are encapsulated by the encapsulation layer 120 to become an encapsulant 100. The encapsulant 100 involves multiple package units 100A which are connected to each other, and each of the package units 100A includes the die 110, the encapsulation layer 120 and the electronic component 150.

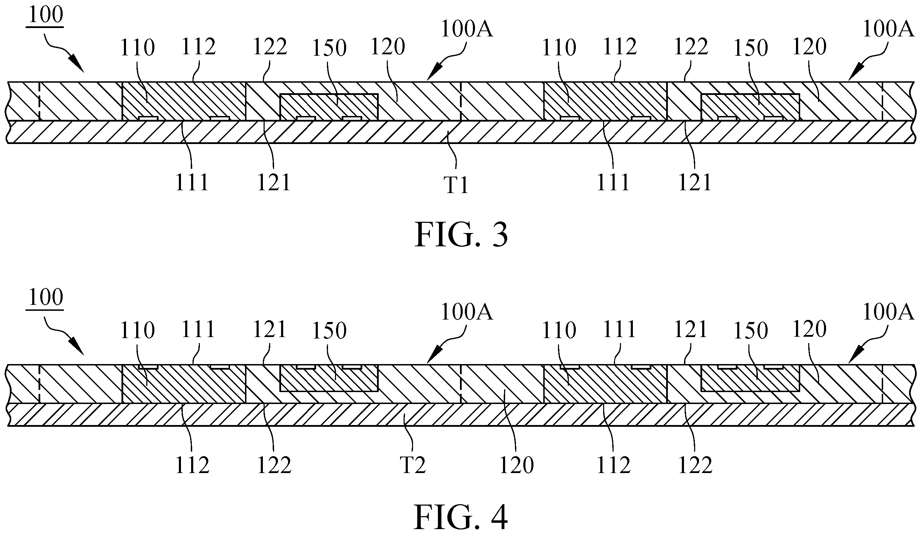

With reference to Fig. 3, the encapsulation layer 120 is thinned after encapsulation of the dies 110 and the electronic components 150 in this embodiment. The back surface 112 of each of the dies 110 can be covered by the thinned encapsulation layer 120 or be visible from the thinned encapsulation layer 120. In other embodiments, the dies 110 and the encapsulation layer 120 are thinned at the same time to allow the back surface 112 of each of the dies 110 to be visible.

With reference to Fig. 4, next, the encapsulant 100 is adhered to a second carrier T2 via the second surface 122 of the encapsulation layer 120 and then the first carrier T1 is removed to expose the active surface 111 of each of the dies 110 and the first surface 121 of the encapsulation layer 120.

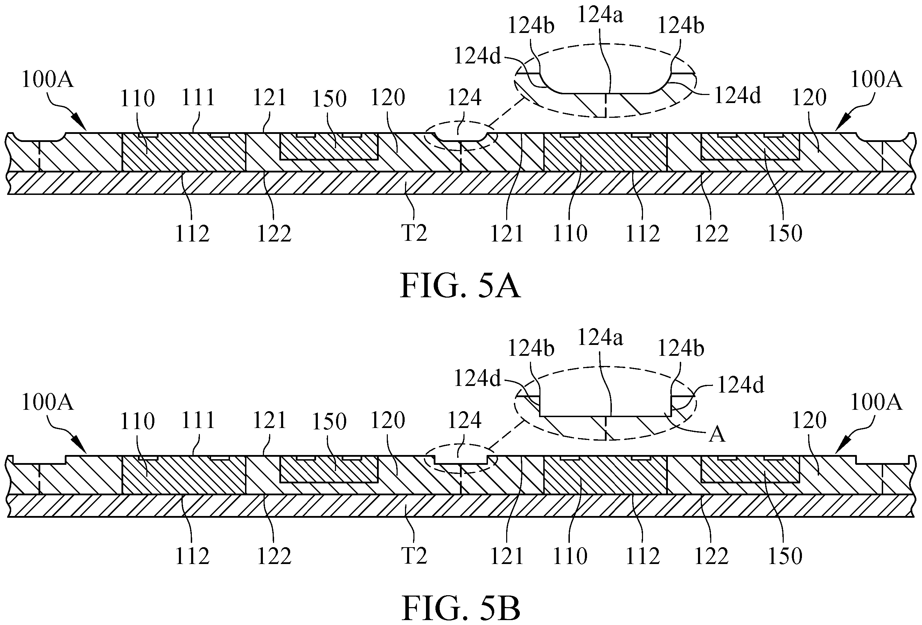

With reference to Figs. 5A to 5D, a groove 124 is formed on the first surface 121 of the encapsulation layer 120. The groove 124 surrounds the first surface 121 of the encapsulation layer 120 and has a bottom surface 124a and two first edges 124b which are opposite to each other and adjacent to the first surface 121. The grooves 124 shown in Figs. 5A to 5D have different cross-sectional shapes.

With reference to Fig. 5A, the groove 124 further has two groove lateral surfaces 124d which are opposite to each other. Each of the groove lateral surfaces 124d is an arc surface connected to the bottom surface 124a. And in this embodiment of Fig. 5A, the groove lateral surfaces 124d are also connected to the first surface 121 of the encapsulation layer 120, and the first edges 124b are located on the groove lateral surfaces 124d, respectively.

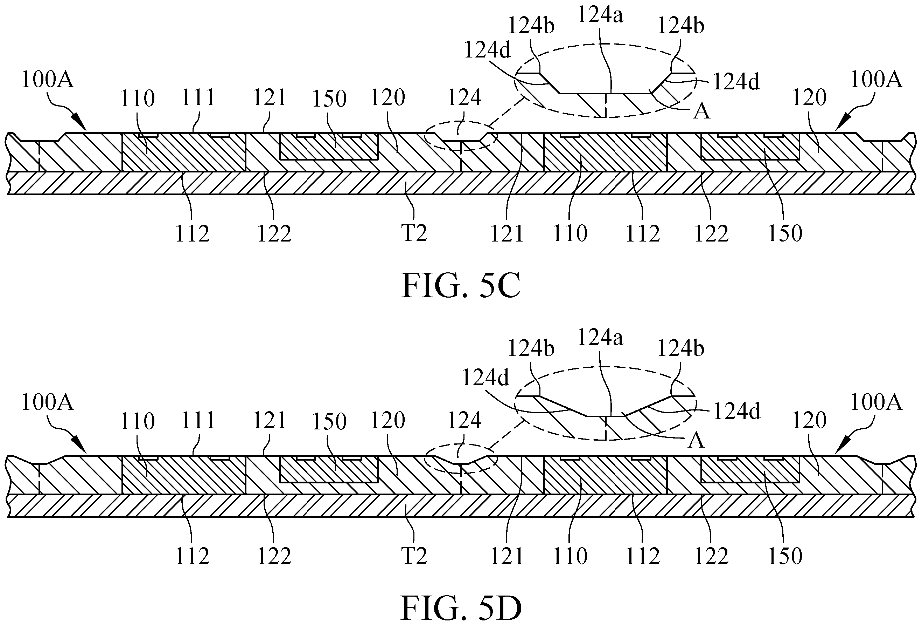

Different to the groove 124 shown in Fig. 5A, an included angle A of not less than 90 degrees exists between the bottom surface 124a and each of the groove lateral surfaces 124d in the embodiments shown in Figs. 5B to 5D. The groove lateral surfaces 124d are perpendicular to the bottom surface 124a in the embodiment of Fig. 5B so the included angle A is 90 degrees, and the included angle A is greater than 90 degrees in the embodiments of Figs. 5C and 5D.

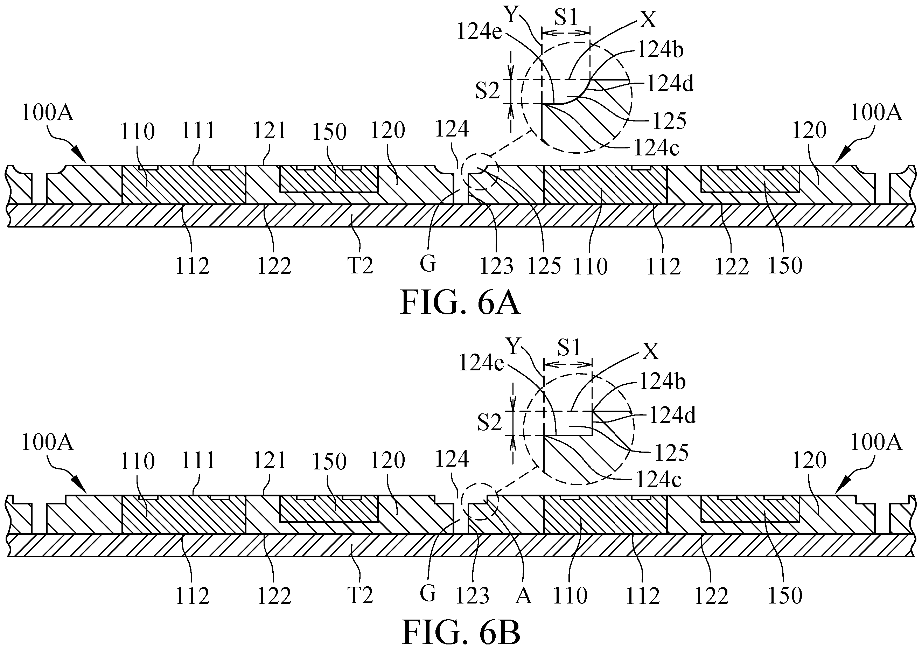

With reference to Figs. 6A to 6D, the encapsulant 100 is cut along the bottom surface 124a of the groove 124 to separate the package units 100A. Meanwhile, the lateral surface 123 of the encapsulation layer 120 is visible and the groove 124 is split into a half groove 125 which surrounds the first surface 121 and is located between the first surface 121 and the lateral surface 123 of the encapsulation layer 120. The half groove 125 has the first edge 124b adjacent to the first surface 121 and the second edge 124c adjacent to the lateral surface 123. The half grooves 125 shown in Figs. 6A to 6D have different cross-sectional shapes.

With reference to Figs. 6A to 6D, the first imaginary line X extending along the first surface 121 of the encapsulation layer 120 passes through the first edge 124b, and the second imaginary line Y extending along the lateral surface 123 of the encapsulation layer 120 passes through the second edge 124c. The first distance S1 from the first edge 124b to the second imaginary line Y is greater than or equal to 3 µm and less than or equal to 10 µm (3 µm ≤ S1 ≤ 10 µm). The second distance S2 from the second edge 124c to the first imaginary line X is greater than or equal to 5 µm and less than or equal to 120 µm (5 µm ≤ S2 ≤ 120 µm). The quotient of S2 divided by S1 is greater than or equal to 0.5 and less than or equal to 40 (0.5 ≤ S2/S1 ≤ 40).

With reference to Fig. 6A, the bottom surface 124a is split into two groove bottom surfaces 124e after separation of the package units 100A. The second edge 124c is located on the groove bottom surface 124e, the groove lateral surface 124d is an arc surface connected to the groove bottom surface 124e and it is located between the groove bottom surface 124e and the first surface 121 of the encapsulation layer 120. In this embodiment of Fig. 6A, the groove lateral surface 124d is connected to the groove bottom surface 124e and the first surface 121 of the encapsulation layer 120, and the first edge 124b is located on the groove lateral surface 124d.

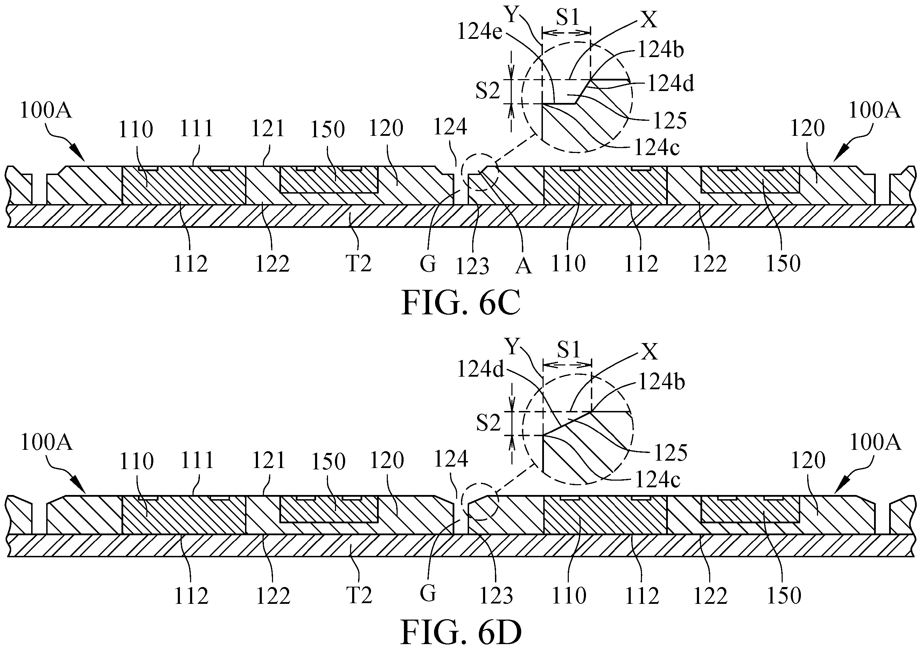

Different to the half groove 125 shown in Fig. 6A, the included angle A of not less than 90 degrees exists between the groove lateral surface 124d and the groove bottom surface 124e in the embodiments shown in Figs. 6B and 6C. The groove lateral surface 124d is perpendicular to the groove bottom surface 124e and the included angle A is 90 degrees in the embodiment of Fig. 6B, and the included angle A is greater than 90 degrees in the embodiment of Fig. 6C.

With reference to Fig. 6D, the bottom surface 124a is removed during separation of the package units 100A, and the groove lateral surface 124d is retained on the half groove 125. Different to the half grooves 125 shown in Figs. 6B and 6C, the groove lateral surface 124d is connected to the first surface 121 and the lateral surface 123 of the encapsulation layer 120, and the first edge 124b and the second edge 124c are located on the groove lateral surface 124d in the embodiment of Fig. 6D.

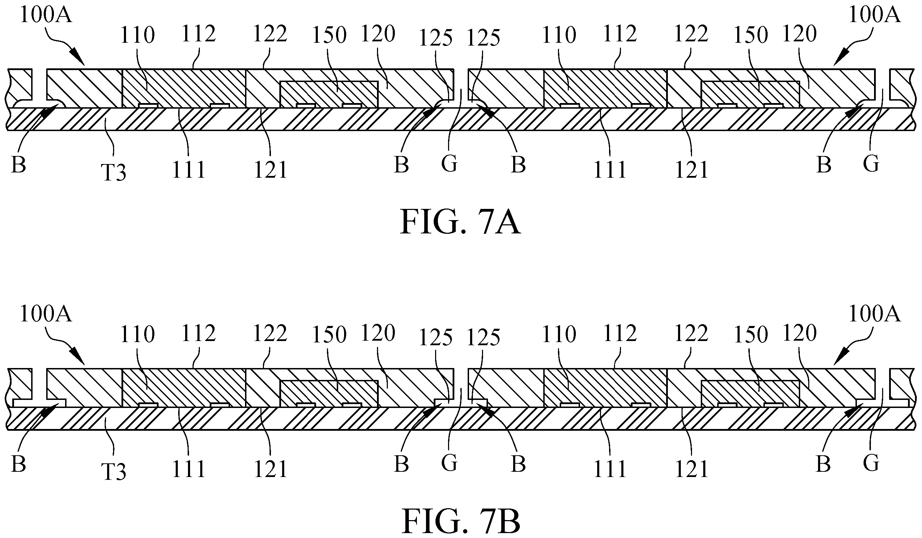

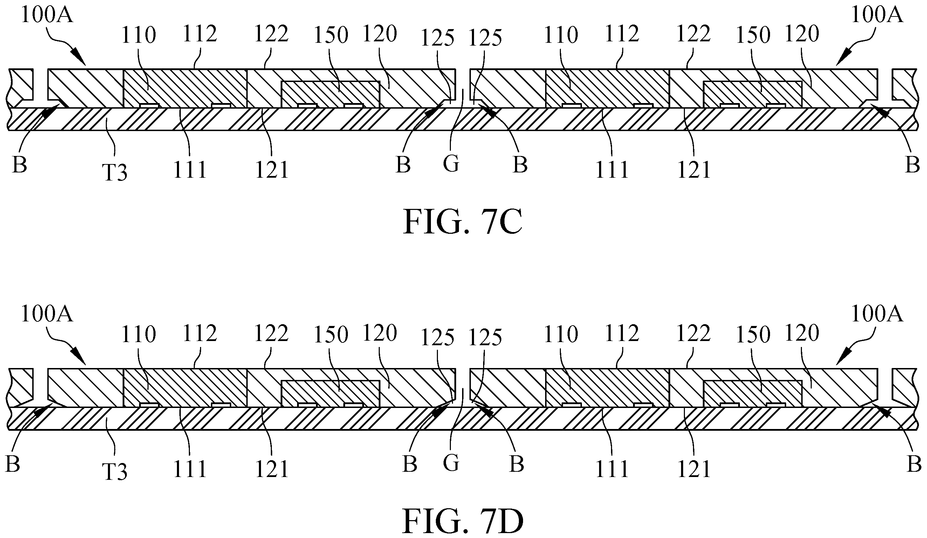

With reference to Figs. 7A to 7D, the package units 100A are adhered to a third carrier T3 via the first surface 121 of the encapsulation layer 120 such that the half groove 125 becomes a sheltering space B located between the encapsulation layer 120 and the third carrier T3. There is a gap G between the adjacent package units 100A, and the gap G is greater than or equal to 20 µm and less than or equal to 1 mm (20 µm ≤ G ≤ 1 mm). Then, the second carrier T2 is removed to show the second surface 122 of the encapsulation layer 120. In other embodiments, the back surface 112 of each of the dies 110 can be visible from the second surface 122 of the encapsulation layer 120. Preferably, the first carrier T1, the second carrier T2 and the third carrier T3 can be adhesive tapes, glass substrates or silicon substrates.

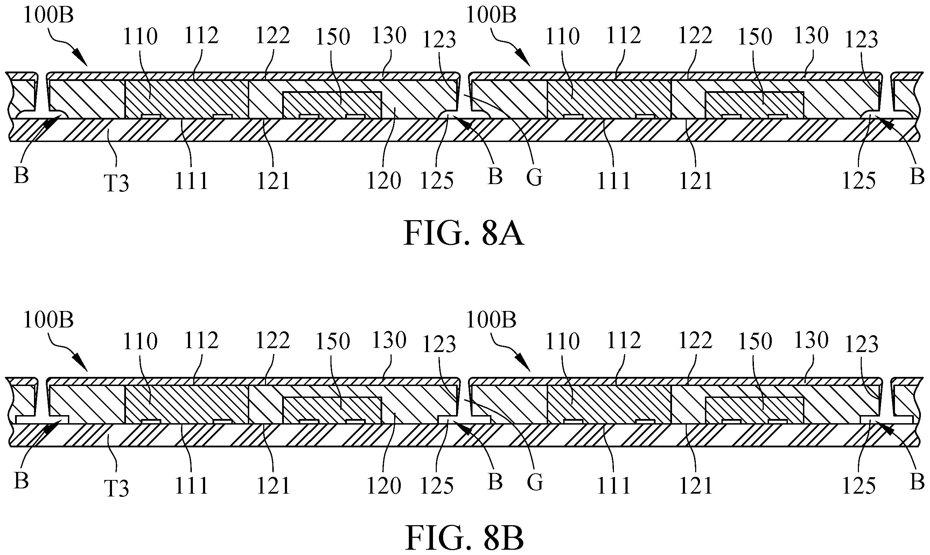

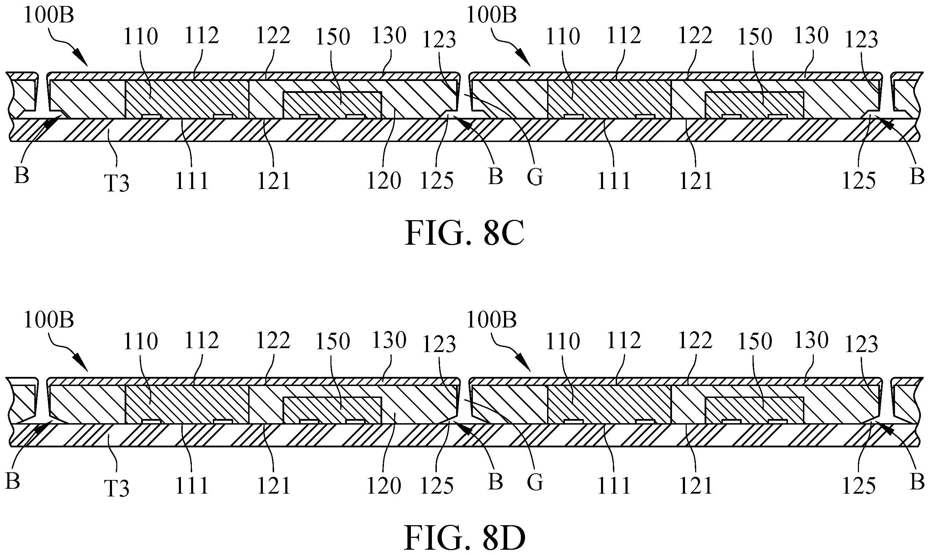

With reference to Figs. 8A to 8D, a heat-dissipation layer 130 is formed on the second surface 122 of the encapsulation layer 120 of each of package units 100A to obtain multiple semiconductor packages 100B. The heat-dissipation layer 130 covers the second surface 122, and preferably, it also covers the lateral surface 123 of the encapsulation layer 120. If the back surface 112 of the die 110 is visible from the second surface 122 of the encapsulation layer 120, the heat-dissipation layer 130 also covers the back surface 112 of the die 110. The heat-dissipation layer 130 can be formed through sputtering process, and the sheltering space B located between the encapsulation layer 120 and the third carrier T3 can prevent spattering target atoms from accumulating in a gap (not shown) between the third carrier T3 and the first surface 121 of the encapsulation layer 120.

With reference to Figs. 9A to 9D, the semiconductor packages 100B can be separated from the third carrier T3 by a robot (not shown) in pick-and-place process.

In the present invention, the groove 124 is formed on the first surface 121 of the encapsulation layer 120 to surround the first surface 121 before separating the package units 100A, and the groove 124 is split into the half groove 125 surrounding the first surface 121 and located between the first surface 121 and the lateral surface 123 after the separation of the package units 100A. The sheltering space B formed because of the half groove 125 is located between the third carrier T3 and the encapsulation layer 120, thus, spattering target atoms will not accumulate in the gap between the third carrier T3 and the first surface 121 of the encapsulation layer 120 to become metal residues which may contaminate the die 110.

While this invention has been particularly illustrated and described in detail with respect to the preferred embodiments thereof, it will be clearly understood by those skilled in the art that is not limited to the specific features shown and described and various modified and changed in form and details may be made without departing from the scope of the claims.

## Claims

1. A semiconductor package (100B) comprising:
a die (110);
an encapsulation layer (120) encapsulating the die (110) and having a first surface (121), a second surface (122), a lateral surface (123) and a half groove (125), wherein the half groove (125) surrounds the first surface (121), is located between the first surface (121) and the lateral surface (123) and has a first edge (124b) adjacent to the first surface (121) and a second edge (124c) adjacent to the lateral surface (123); and
a heat-dissipation layer (130) covering the second surface (122).

2. The semiconductor package (100B) in accordance with claim 1, wherein a back surface (112) of the die (110) is visible from the second surface (122) of the encapsulation layer (120) and is covered by the heat-dissipation layer (130).

3. The semiconductor package (100B) in accordance with claim 1 or 2, wherein a first imaginary line (X) extending along the first surface (121) of the encapsulation layer (120) passes through the first edge (124b), and a second imaginary line (Y) extending along the lateral surface (123) of the encapsulation layer (120) passes through the second edge (124c), a first distance (S1) from the first edge (124b) to the second imaginary line (Y) is greater than or equal to 3 µm and less than or equal to 10 µm, a second distance (S2) from the second edge (124c) to the first imaginary line (X) is greater than or equal to 5 µm and less than or equal to 120 µm, and a quotient of the second distance (S2) divided by the first distance (S1) is greater than or equal to 0.5 and less than or equal to 40.

4. The semiconductor package (100B) in accordance with one of claims 1 to 3, wherein the half groove (125) further has a groove lateral surface (124d) and a groove bottom surface (124e), the groove lateral surface (124d) is an arc surface connected to the groove bottom surface (124e), and the second edge (124c) is located on the groove bottom surface (124e).

5. The semiconductor package (100B) in accordance with one of claims 1 to 3, wherein the half groove (125) further has a groove lateral surface (124d) and a groove bottom surface (124e), the groove lateral surface (124d) is connected to the groove bottom surface (124e) and the first surface (121) of the encapsulation layer (120), there is an included angle (A) greater than or equal to 90 degrees between the groove lateral surface (124d) and the groove bottom surface (124e), the first edge (124b) is located on the groove lateral surface (124d) and the second edge (124c) is located on the groove bottom surface (124e).

6. The semiconductor package (100B) in accordance with one of claims 1 to 3, wherein the half groove (125) further has a groove lateral surface (124d) which is a sloping surface, the groove lateral surface (124d) is connected to the first surface (121) and the lateral surface (123) of the encapsulation layer (120), and the first edge (124b) and the second edge (124c) are located on the groove lateral surface (124d).

7. A method of manufacturing semiconductor packages (100B) comprising:
adhering a plurality of package units (100A) to a third carrier (T3), each of the plurality of package units (100A) includes an encapsulation layer (120) and a die (110) encapsulated by the encapsulation layer (120), the encapsulation layer (120) has a first surface (121), a second surface (122), a lateral surface (123) and a half groove (125), the half groove (125) surrounds the first surface (121), is located between the first surface (121) and the lateral surface (123) and has a first edge (124b) adjacent to the first surface (121) and a second edge (124c) adjacent to the lateral surface (123), wherein the first surface (121) of the encapsulation layer (120) is adhered on the third carrier (T3) such that the half groove (125) becomes a sheltering space (B) between the encapsulation layer (120) and the third carrier (T3); and
forming a heat-dissipation layer (130) on the second surface (122) of the encapsulation layer (120) of each of the plurality of package units (100A) to obtain a plurality of semiconductor packages (100B).

8. The method in accordance with claim 7 further comprising a packaging process, wherein a plurality of dies (110) are adhered to a first carrier (T1) via an active surface (111) of each of the plurality of dies (110) and encapsulated by the encapsulation layer (120) to obtain an encapsulant (100), the encapsulant (100) includes the plurality of package units (100A) which are connected to one another and the encapsulant (100) is adhered to a second carrier (T2) via the second surface (122) of the encapsulation layer (120), the first carrier (T1) is removed to allow the first surface (121) of the encapsulation layer (120) to be visible, a groove (124) is formed on the first surface (121) of the encapsulation layer (120), the groove (124) surrounds the first surface (121) of the encapsulation layer (120) and has a bottom surface (124a) and two opposite first edges (124b), the encapsulant (100) is cut along the bottom surface (124a) of the groove (124) to separate the plurality of package units (100A) and allow the lateral surface (123) of the encapsulation layer (120) to be visible, the groove (124) is split to the half groove (125), and the second carrier (T2) is removed to allow the second surface (122) of the encapsulation layer (120) to be visible after adhering the plurality of package units (100A) to the third carrier (T3).

9. The method in accordance with claim 8, wherein the encapsulation layer (120) is thinned after encapsulating the plurality of dies (110).

10. The method in accordance with claim 8 or 9, wherein a gap (G) between the adjacent package units (100A) which are adhered to the third carrier (T3) is greater than or equal to 20 µm and less than or equal to 1 mm.

11. The method in accordance with one of claims 7 to 10, wherein a first imaginary line (X) extending along the first surface (121) of the encapsulation layer (120) passes through the first edge (124b), and a second imaginary line (Y) extending along the lateral surface (123) of the encapsulation layer (120) passes through the second edge (124c), a first distance (S1) from the first edge (124b) to the second imaginary line (Y) is greater than or equal to 3 µm and less than or equal to 10 µm, a second distance (S2) from the second edge (124c) to the first imaginary line (X) is greater than or equal to 5 µm and less than or equal to 120 µm, and a quotient of the second distance (S2) divided by the first distance (S1) is greater than or equal to 0.5 and less than or equal to 40.

12. The method in accordance with one of claims 8 to 11, wherein the groove (124) further has two opposite groove lateral surfaces (124d), each of the groove lateral surfaces (124d) is an arc surface connected to the bottom surface (124a), the bottom surface (124a) is split into two groove bottom surfaces (124e) after separating the plurality of the package units (100A), each of the groove lateral surfaces (124d) is connected to one of the groove bottom surfaces (124e) and is located between one of the groove bottom surfaces (124e) and the first surface (121) of the encapsulation layer (120), the second edge (124c) is located on the groove bottom surfaces (124e).

13. The method in accordance with claim 12, wherein the groove lateral surfaces (124d) are connected to the first surface (121) of the encapsulation layer (120), and the first edge (124b) is located on the groove lateral surfaces (124d).

14. The method in accordance with one of claims 8 to 11, wherein the groove (124) further has two opposite groove lateral surfaces (124d), each of the groove lateral surfaces (124d) is connected to the bottom surface (124a) and the first surface (121) of the encapsulation layer (120), there is an included angle (A) greater than or equal to 90 degrees between the bottom surface (124a) and each of the groove lateral surfaces (124d), the bottom surface (124a) is split into two groove bottom surfaces (124e) after separating the plurality of package units (100A), each of the groove lateral surfaces (124d) is connected to one of the groove bottom surfaces (124e) and the first surface (121) of the encapsulation layer (120), there is the included angle (A) between each of the groove lateral surfaces (124d) and each of the groove bottom surfaces (124e), the first edge (124b) is located on the groove lateral surfaces (124d), and the second edge (124c) is located on the groove bottom surfaces (124e).

15. The method in accordance with one of claims 8 to 11, wherein the groove (124) further has two opposite groove lateral surfaces (124d) connected to the bottom surface (124a), there is an included angle (A) greater than 90 degrees between the bottom surface (124a) and each of the groove lateral surfaces (124d), the bottom surface (124a) is removed during separating the plurality of package units (100A), each of the groove lateral surfaces (124d) is retained on the half groove (125) and is connected to the first surface (121) and the lateral surface (123) of the encapsulation layer (120), and the first edge (124b) is located on the groove lateral surfaces (124d).
